Europäisches Patentamt

European Patent Office

Office européen des brevets

(19)

(11) **EP 1 024 450 A1**

(12) **EUROPEAN PATENT APPLICATION**

(43) Date of publication:
02.08.2000 Bulletin 2000/31

(51) Int. Cl.⁷: **G06G 7/24**

(21) Application number: 00300355.5

(22) Date of filing: 19.01.2000

(84) Designated Contracting States:
**AT BE CH CY DE DK ES FI FR GB GR IE IT LI LU MC NL PT SE**
Designated Extension States:
**AL LT LV MK RO SI**

(30) Priority: **30.01.1999 US 117804 P**
**10.11.1999 US 437273**

(71) Applicant:
**LUCENT TECHNOLOGIES INC.**
**Murray Hill, New Jersey 07974-0636 (US)**

(72) Inventors:
• **Gabara, Thaddeus John**
**Murray Hill, New Jersey 07974 (US)**
• **Moerz, Matthias**
**81369 Muenchen (DE)**

(74) Representative:
**Buckley, Christopher Simon Thirsk et al**
**Lucent Technologies UK Ltd,**
**Intellectual Property Division,**
**5 Mornington Road**
**Woodford Green, Essex IG8 0TU (GB)**

(54) **Analog decoding arrangement**

(57)    The boxplus and other functions are realized with an arrangement that, in its most basic form, includes a current source connected to layer block followed by a passive interconnection block that is interposed between the layer block and an exponential load block. Different functions can be realized by selecting the interconnections in the interconnection block, by selecting the signals that are applied to the multiple inputs that the layer block contains, and by selecting the ports in the exponential load block where voltages are sensed. Also, different functions can be realized by employing layers of alternating layer blocks and interconnection blocks. Those layers can be folded to allow the circuits to work effectively even with low battery voltages.

FIG. 3

EP 1 024 450 A1

# Description

## Related Application:

This application claims priority under application number 60/117,804 filed on January 30, 1999.

## Background Of The Invention:

This invention relates to analog circuits and, more particularly, to analog encoder-decoder circuits.

Advanced error correction codes are an essential part of many modern transmission systems both for wireless and wired applications. In contrast to many other signal processing tasks in communications, the encoding and decoding of error-correcting codes has always been implemented digitally. Recently, however, some researchers have become interested in analog decoders, as evidenced, for example, by the following publications: Shakiba et al proposed analog Viterbi decoders in "BiCOMS circuits for analog Viterbi decoders, IEEE Trans, Circuits and Sys. II, vol. 45, Dec. 1998, pp. 1527-37; and Wang et al in "An artificial neural net Viterbi decoder," IEEE Trans. Comm., vol. 44, Feb. 1996, pp. 165-71. The main attraction of analog decoders is that the iterations that are so typical in digital circuits disappears completely. The analog decoder is just an asynchronous circuit whose transfer function is such that, in response to input signals, stabilizes to a state that corresponds to the decoded codeword. In that sense, the analog decoders are similar to the analog neural networks proposed by Hopfield et al. See, for example, US Patent 4,937,872.

A very famous application for the series connection of differential transistor pairs is the so-called Gilbert multiplier. The circuit described by Gilbert in "A new wide-band amplifier technique," IEEE Journal of Solid-State Circuits, vol. SC-3, No. 4, December 1968, pp 358-373, provides a temperature independent linearization technique in order to perform wide range real number multiplications. Influenced by work on analog decoder carried out by Hagenauer et al in "The analog decoder," ISIT'98, Cambridge, MA, USA, August 1998, Loelinger et al proposed analog decoder circuits in "Probability propagation and decoding in analog VLSI," ISIT'98, Cambridge, MA, USA, August 1998. They employed Gilbert's linearization technique for probability multiplications and probability processing.

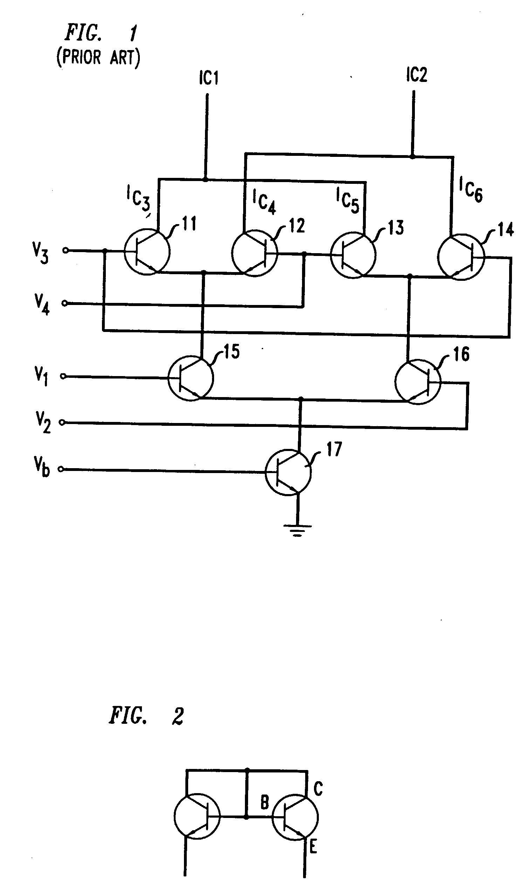

FIG. 1 depicts a Gilbert multiplier realization. It uses a configuration where the two uppers pairs of emitter coupled pairs have their collectors cross coupled. That is, while the emitters of transistors 11 and 12 are interconnected, and the emitters of transistors 13 and 14 are interconnected, the collectors of transistors 11 and 13 are interconnected to form a first output current source, $I_{C1}$, and the collectors of transistors 12 and 14 are interconnected to form a second output current source, $I_{C2}$. The two emitters of transistors 11 and 12 are connected to the collector of transistor 15, and the two emitters of transistors 13 and 14 are connected to the collector of transistor 16. The emitters of transistors 15 and 16 are both connected to the collector of transistor 17, whose emitter is connected to ground.

Separately, a "boxplus" or function was defined by Hagenauer as the inverse hyperbolic tangent of the product of two hyperbolic tangent functions.

## Summary

The boxplus and other functions are realized with an arrangement that, in its most basic form, includes a current source connected to layer block followed by a passive interconnection block that is interposed between the layer block and an exponential load block. Different functions can be realized by selecting the interconnections in the interconnection block, by selecting the signals that are applied to the multiple inputs that the layer block contains, and by selecting the ports in the exponential load block where voltages are sensed. Also, different functions can be realized by employing layers of alternating layer blocks and interconnection blocks. Those layers can be folded to allow the circuits to work effectively even with low battery voltages.

## Brief Description Of The Drawing

FIG. 1 presents the prior art Gilbert multiplier circuit;

FIG. 2 presents an exponential load block having two elements;

FIG. 3 is a diagram of a circuit for realizing the boxplus function through use of the Gilbert multiplier and the exponential load block;

FIG. 4 presents a generalized view -- in three different forms -- of a building block that comprises a layer block followed by an interconnection block;

FIG. 5 presents two boxplus realization, where one is with one type of device, such as npn transistors, and the other is with the complementary type of device, such as pnp transistors;

FIG. 6 illustrates a layer block that is made up from a number of simpler layer blocks;

FIG. 7 depicts a totem pole, or serial connection, multi-layer construct employing a current source, multiple layer blocks, interleaved interconnection blocks, and an exponential load block connected to the last interconnection block;

FIGS. 8-12 illustrate different circuits that employ the principles disclosed herein;

FIG. 13 shows a boxplus function block in accordance with the principles disclosed herein that includes input and output interface circuits;

FIG. 14 shows a summer block in accordance with the principles disclosed herein that includes input and output interface circuits;

FIG. 15 shows a folded construct that employs current mirrors; and

FIG. 16 shows a folded construct that employs current mirrors between layers that alternately utilize different types of active devices.

## Detailed Description

It can be shown that the Gilbert multiplier results in exactly the product of two hyperbolic tangent functions. That is, $\Delta I = I_{c1} - I_{c2} = K \cdot \tanh(k_1 V_{d1}) \tanh(k_2 V_{d2})$, , where $K$, $k_1$, and $k_2$ are constants. Hence, the Gilbert multiplier can be used to implement a boxplus function, if one can generate an inverse hyperpolic tangent function which is applied to the difference of the Gilbert multiplier outputs.

One possibility for implementing a hyperbolic tangent inverse is to use one or more operational amplifiers as a function generator, in order to approximate the desired function. Such an approach, however, would require a large number of transistors. We simply propose to use a circuit such as the one depicted in FIG. 2, with two diode-connected transistors (the C, B and E stand for collector, base, and emitter, respectively). Such a circuit is sometimes applied to the inputs of a Gilbert multiplier as a pre-distortion circuit in order to compensate for nonlinearities. If the two currents $I_{c13}$ and $I_{c14}$ in the FIG. 2 circuit happen to be $I+\Delta I$ and $I-\Delta I$, respectively, one can realize (by employing of the well known transistor relationship

$$I_c \approx I_s e^{kV_{BE}} ,$$

where $k$ is a constant, $I_s$ is the saturation current and $I_c$ is the collector current) that the differential output voltage $\Delta v = v_{c13} - v_{c14}$ is equal to

$$\Delta v = Q \cdot \tanh^{-1}(q\Delta I), \qquad (1)$$

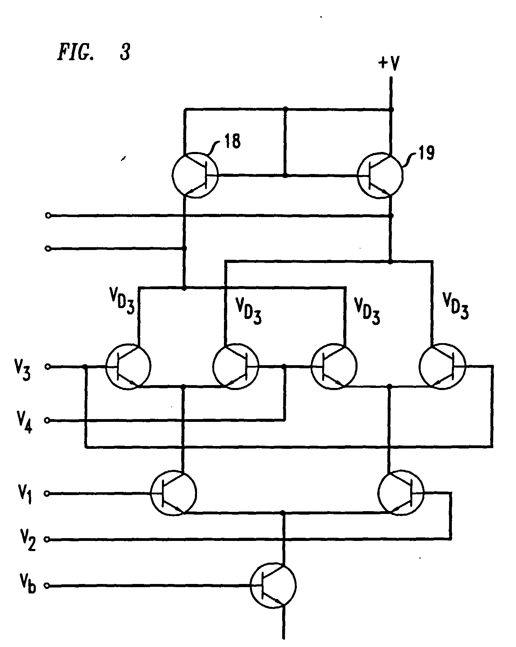

where Q and q are constants. Therefore we involve the FIG. 2 circuit at the output of the Gilbert multiplier, realizing thereby the special nonlinear function provided by the boxplus function. This results in the circuit of FIG. 3, where transistors 18 and 19 form the exponential loads.

We realized that, in fact, many useful circuits can be obtained by connecting an exponential load to what is a current source. The current source may be a combination of currents drawn by any number of transistors, and the load can be any load that effectively has an exponential (or, inversely, a logarithmic) voltage-current relationship and which is not used as a current source. There are many elements known in the art that can be used as the exponential load, and there are many means for creating one or more current sources. In the context of this disclosure, only the functionality matters.

Also, it is obvious that the $\Delta v$ voltage needs to be sensed. Theoretically, any sensing of the voltage affects the transfer function of the equivalent load that the current source sees. However, when the voltage sensing is via a very high impedance port, that effect is negligible and the equivalent load effectively still presents an exponential voltage-current relationship.

For purposes of this disclosure, wherever a voltage must be sensed, it is assumed that it is sensed with a high enough impedance so as to not affect the equivalent characteristic of the circuit where the sensing takes place.

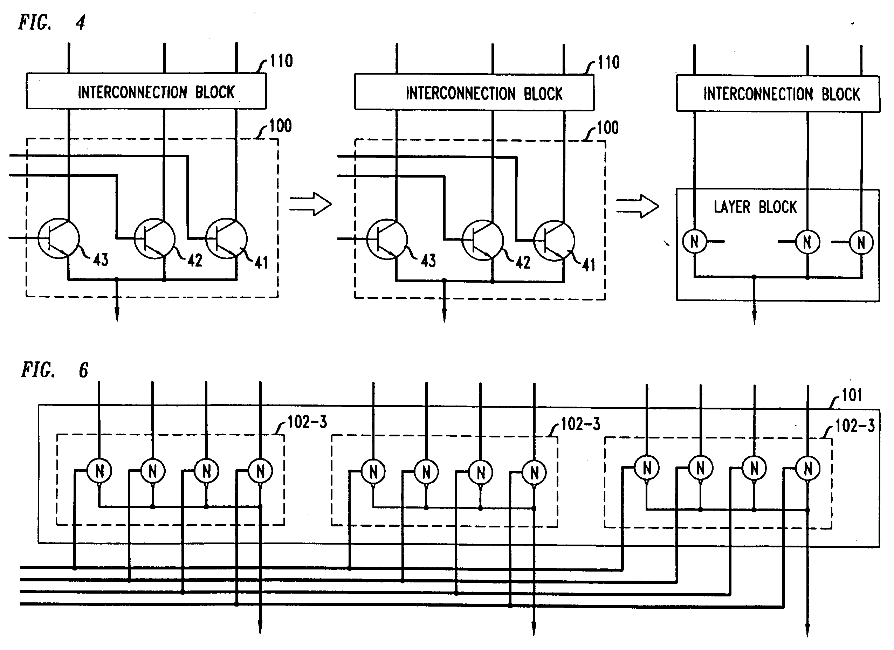

Thus, in accordance with the principles disclosed herein, we employ a generalized circuit That has the FIG. 4 structure. Specifically, it comprises a layer block 100 and an interconnection block 110. Layer block 100 is shown with a plurality of npn transistors 41, 42 ...., 43, where the emitters are all interconnected and form a first -- type A -- output lead of the layer block. The bases of the transistors are connected to input ports of the block, and the collectors of the transistors are connected to output leads of the layer block, which for convenience we term type B output leads of the layer block. Interconnection block 110 is a passive block. It has a number of input leads that correspond to the number of type B output leads of the layer block, and a number of output leads that is equal to, or less then, the number of input leads. In the FIG. 4 depiction, there is an equal number of input and output leads in the interconnection block. The function of the interconnection block, as the name implies, is to connect all the input leads to the output leads.

In use, the FIG. 4 circuit has its type A output lead connected to a current source. The type B output leads have a greater connection freedom. If the lead is usefully employed, however, it is connected only to form a current source for some other circuit, or it is connected to an exponential load. In all cases, however, voltage sensing can be had of any type B output lead. The functionality of the circuit is dictated by the interconnections in the interconnection block, by the input signals that are applied to the input terminals of the active devices in the layer block, and by the particular ports of the exponential load block from which voltage levels are sensed.

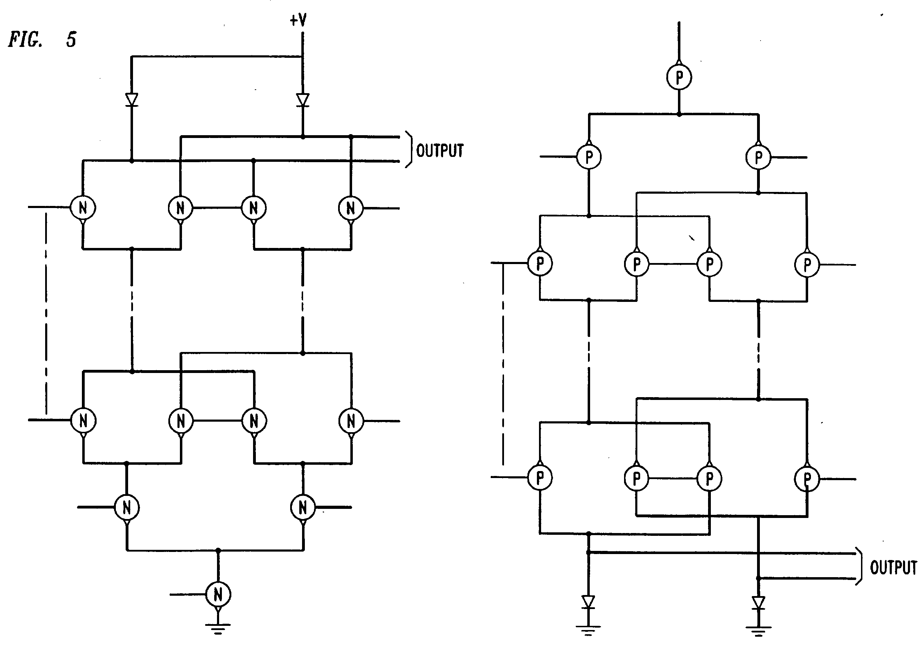

It may be noted that FIG. 4 presents three representations of the same layer block 100. The right-most is the most compact depiction and is used in subsequent FIGs. It may be also noted that a completely equivalent layer block can be created using pnp transistors. To illustrate, FIG. 5 presents the boxplus function realization for both npn and pnp transistors.

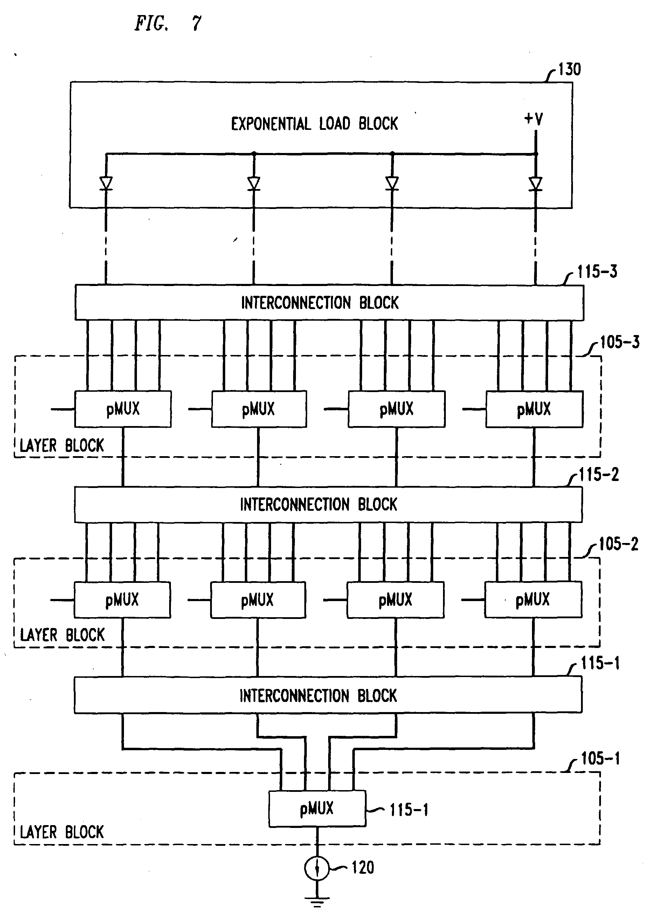

FIG. 6 presents a generalized view of the FIG. 4 circuit, which effectively includes more than one FIG. 4 circuit in a single layer block. That is, layer block 101 of FIG. 6 comprises sets of active devices 102-1, 102-2, 102-3, and each set is connected as described above in connection with FIG. 4.

FIG. 7 presents a construct for a general decoder circuit. It includes any desired number of layers, each of which comprises a layer block 105-i followed by an interconnection block 115-i. The first layer block has its type A output leads each connected to a current source, such as current source 120, and the output ports of the last interconnection block (if they are usefully employed) are connected to exponential loads in a load block 130.

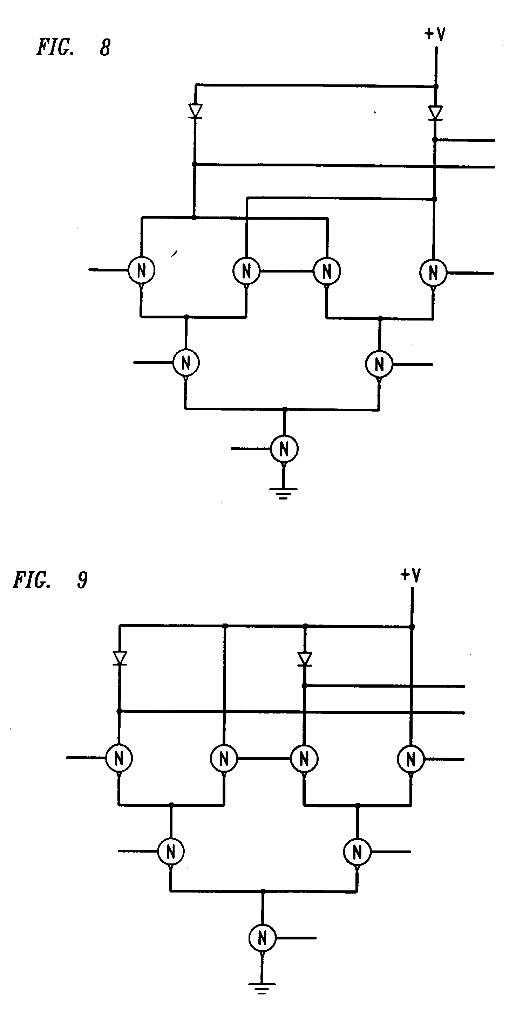

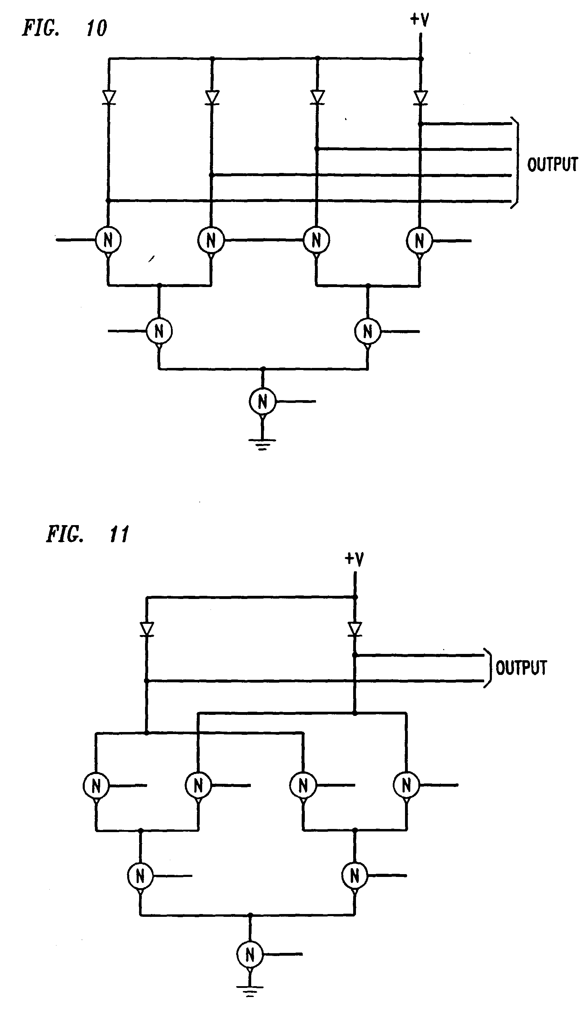

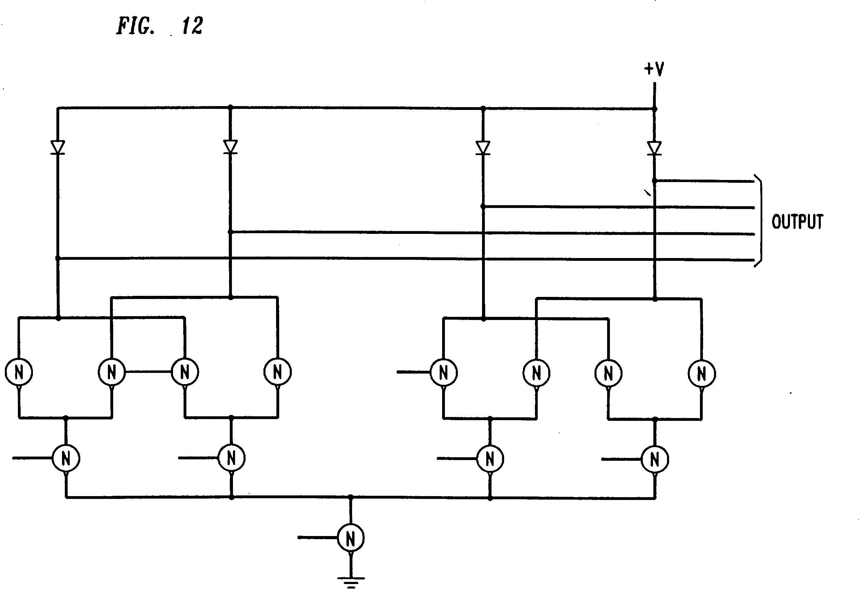

To illustrate the versatility of circuits constructed in accordance with the principles of disclosed herein, FIGs. 8 - 12 show different decoder realizations.

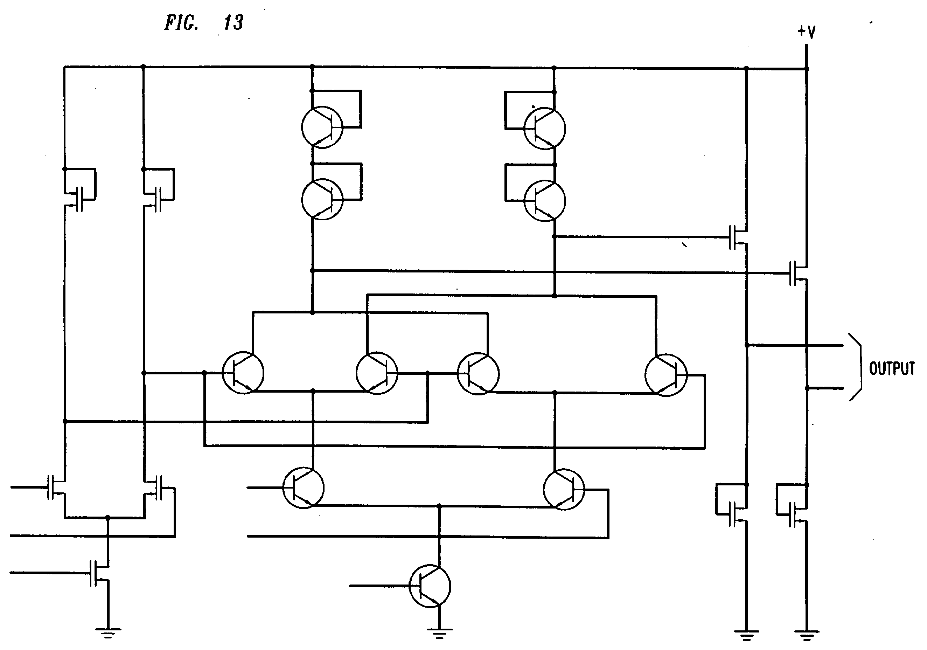

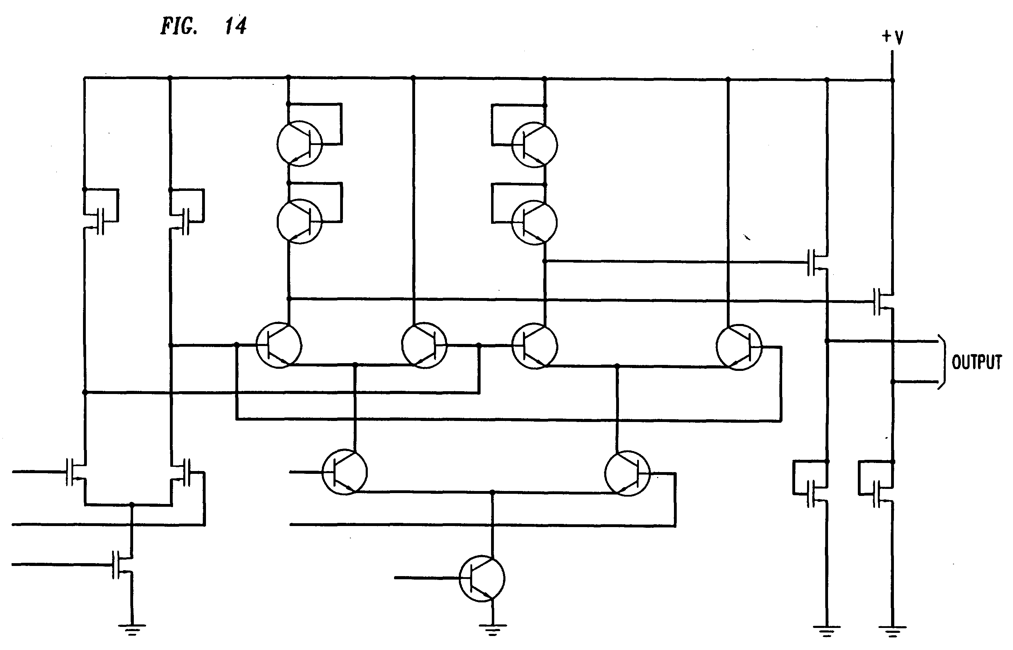

FIG. 13 shows a boxplus building block with a CMOS input stage, a bipolar boxplus circuit, and a CMOS output stage; and FIG. 14 shows a summer building block with a CMOS input stage, a bipolar summer circuit, and a CMOS output stage. It may be noted that the exponential load elements in FIGS. 13 and 14 consist of two diode-connected transistors that are connected serially. Functionally, the series connection is still an exponential load element. The two transistors are used to provide a proper bias to the voltage sensing FETs.

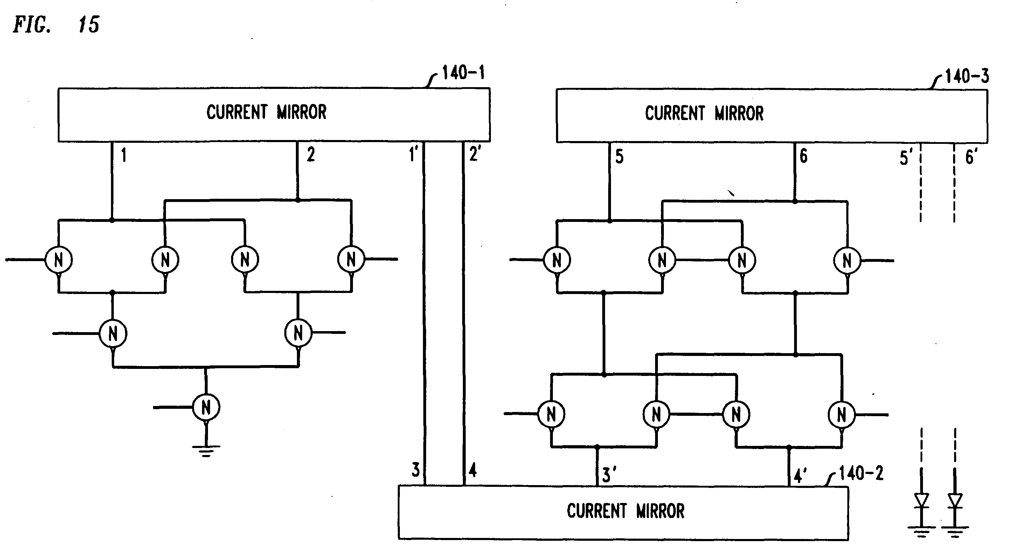

The general construct as illustrated in FIG. 7 has a totem pole structure, which may present a problem with supply voltages that are low. To overcome this problem, in accordance with another set of principles disclosed herein, the totem pole structure of FIG. 7 is folded with the aid of a current mirror block. This is illustrated in FIG. 15.

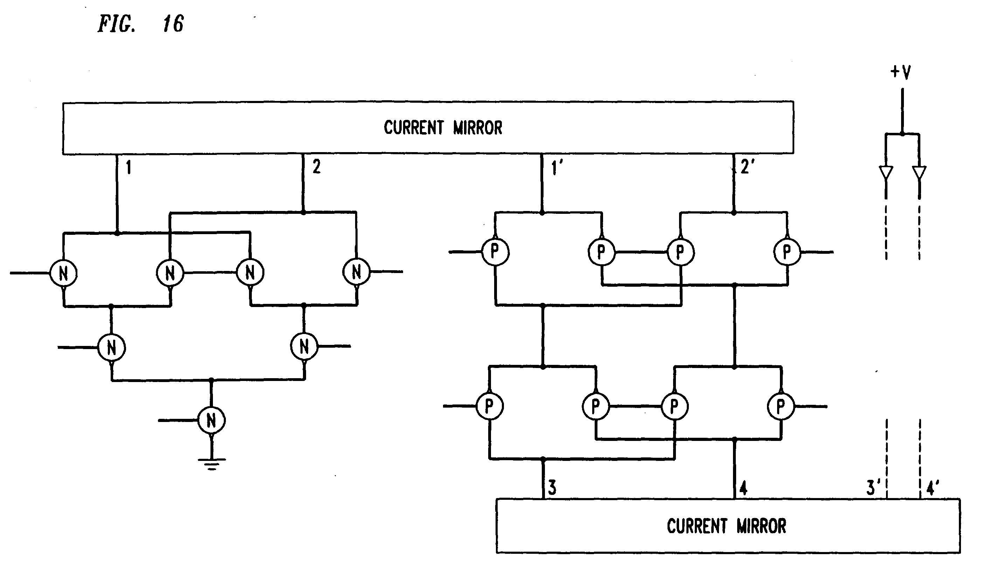

As indicated above, the basic construct disclosed herein can be implemented with one type of active device, such as npn transistors, and well as with another type of active device, such as pnp transistors. The same applied to the folded embodiment of FIG. 15. This is illustrated in FIG. 16.

**Claims**

1.  An arrangement comprising:

    a first layer block having at least two active devices that have at least three types of terminals each, where one type of terminal of each of the active devices is connected to a common point that is coupled to a type A output lead of said layer block, and another type of terminal of each of the active devices is coupled to a respective type B output lead of said layer block, and

an exponential load device connected between at least one of the type B output terminals of said layer block and a point of fixed potential.

2.  The arrangement of claim **1** wherein said layer block has a plurality of input leads, each of which is connected to a third type of terminal of each of the active devices.

3.  The arrangement of claim **1** further comprising a sensing load connected to said at least one of the type B output terminals to which said exponential load device is connected.

4.  The arrangement of claim **1** where a separate exponential load device is connected each of said type B outputs leads of said layer block.

5.  The arrangement of claim **4** where said separate exponential load devices form a load block having a first port that is connected to a point of fixed potential and a number of second ports, each of which being respectively connected to said type B output leads of said layer block.

6.  The arrangement of claim **1** where said layer block has more than two of said active devices

7.  The arrangement of claim **1** where said active devices are transistors, where said one type of terminal of each of said active devices is a drain, source, emitter, or collector, and said another type of terminals of each of said active devices is the source, drain, collector, or emitter, respectively.

8.  The arrangement of claim **1** further comprising a current source connected between said type A output lead of said layer block and a point of fixed potential.

9.  The arrangement of claim **1** where said layer block is a first layer block, and said arrangement further comprises a second layer block having one of its type B output leads connected to said type A output lead of said first layer block.

10. An arrangement comprising:

    a layer block having *N* active devices, where *N* is an integer greater than 1, where said devices have at least three types of terminals each, where one type of terminal of each of the devices is connected to a common point that is coupled to a type A output lead of said layer block, and another type of terminal of each of the devices is coupled to a respective type B output lead of said layer block, thus forming $N$ type B output leads of said layer block;

an interconnection block having $N$ first ports and $M$ second ports that passively interconnects said $N$ ports to said $M$ ports, where $M$ is an integer and where said $N$ ports are connected to said $N$ type B output leads of said layer block; and

a load block comprising $M$ exponential load devices, all of them having one lead connected to a point of fixed potential, and each of them having another lead connected to a corresponding output port of said load block, thus forming M output ports of said load block, where said $M$ output ports of said load block are respectively connected to said $M$ second ports of said interconnection block.

**11.** The arrangement of claim **10** where $M$ is less than or equal to $N$.

**12.** An arrangement comprising:

a layer block having $K$ sets, each set comprising $N_k$ of active devices, where $K$ is greater than 0 and each $N_k$ is an integer greater than 1, where said devices have at least three types of terminals each, where one type of terminal of each of the devices in a set is connected to a common point that is coupled to a type A output lead of said layer block, and another type of terminal of each of the devices is coupled to a respective type B output lead of said layer block, thus forming $K$ type A output leads of said layer block and $K$ sets of type B output leads of said layer block, each having $N_k$ type B output leads;

an interconnection block having $L$ first ports and $M$ second ports that passively interconnects said $L$ ports to said $M$ ports, where $L$ and $M$ are integers greater than 1 and where said $L$ ports are connected to at least two type B output leads of said layer block; and

a load block comprising $M$ exponential load devices having one lead connected to a point of fixed potential, and another lead connected to an output port of said load block, thus forming $M$ output ports of said load block, where said $M$ output ports of said load block are respectively connected to said $M$ second ports of said interconnection block.

**13.** The arrangement of claim **14** where $L$ is equal to the

$$\sum_{i=1}^{K} N_i$$

**14.** A Gilbert multiplier having two output ports, with the improvement comprising:

an exponential load connected to one or both of said output ports.

**15.** The arrangement of claim **12** where said layer block is a first layer block that comprises two sets of active devices, each having two active devices, developing thereby two type A output leads and four type B output leads, said interconnection layer has four first ports connected to said four type B output leads of said layer block and two second ports, and said load block comprises two exponential load devices each having one lead connected to a respective one of the two second output ports of said interconnection block, and another lead of said exponential load devices connected to a point of fixed potential, further comprising:

a second layer block having two active devices and two type B output leads that are connected to two the type A output lead of said first layer block; and

a current source connected to type A output lead of said second layer block.

**16.** An arrangement comprising:

a current source block;

an exponential load block, and

a plurality of interconnected serially connected blocks, each of which includes a layer sub-block followed by an interconnection sub-block, with the first layer sub-block in said serially connected blocks connected to said current source block that provides one or more current sources, where

each layer block comprises one or more sets of active devices that have at least three types of terminals, each set of which has one type of terminal of the active devices in the set interconnected and forming a type A output lead of the layer sub-block, and each set of which has another type of terminal of the active devices in the set connected to type B output leads of the layer subblock, where type A output leads of a sub-block are connected to an interconnection sub-block of an immediately previous layer block and where type B output leads of a sub-block are connected to an interconnection sub-block of an immediately subsequent layer block; and where at least some type B output leads of the last interconnection sub-block in said serially connected blocks are connected to said exponential load block.

17. The arrangement of claim **16** where at least some type B output leads in said serially connected blocks of other than the last interconnection sub-block in said serially connected blocks are connected to said exponential load block.

18. The arrangement of claim **16** further comprising a connection to at least two of ports of said exponential load block for sense voltage.

19. An arrangement, comprising a plurality of building block that are interconnected with current mirror blocks to form a series connection of building blocks with interposed current mirror blocks, comprising:

a current source connected to the first of the building blocks in said series connection of building blocks with interposed current mirror blocks; and

an exponential load block connected to the last of the building blocks in said series connection of building blocks with interposed current mirror blocks.

20. The arrangement of claim **19** where adjacent building block that are interposed with current mirror blocks employ complementary types of active devices.

*FIG. 1*
(PRIOR ART)

*FIG. 2*

FIG. 3

*FIG. 4*

INTERCONNECTION BLOCK   110

100

43   42   41

⟹

INTERCONNECTION BLOCK   110

100

43   42   41

⟹

INTERCONNECTION BLOCK

LAYER BLOCK

Ⓝ   Ⓝ   Ⓝ

*FIG. 6*

101

102-3   102-3   102-3

Ⓝ Ⓝ Ⓝ Ⓝ   Ⓝ Ⓝ Ⓝ Ⓝ   Ⓝ Ⓝ Ⓝ Ⓝ

FIG. 5

FIG. 7

**FIG. 8**

**FIG. 9**

FIG. 10

FIG. 11

FIG. 12

OUTPUT

+V

EP 1 024 450 A1

FIG. 13

EP 1 024 450 A1

FIG. 14

OUTPUT

+V

16

EP 1 024 450 A1

FIG. 15

CURRENT MIRROR 140-1

CURRENT MIRROR 140-3

CURRENT MIRROR 140-2

EP 1 024 450 A1

FIG. 16

European Patent Office

## EUROPEAN SEARCH REPORT

Application Number

EP 00 30 0355

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 764 559 A (KIMURA KATSUJI) 9 June 1998 (1998-06-09) | 1-8, 10-12 | G06G7/24 |
| Y | * column 3, line 49 - column 4, line 17; figure 2 * | 14,16,19 | |
| Y | US 4 374 335 A (NISHIKAWA YUKIO ET AL) 15 February 1983 (1983-02-15) * column 3, line 38 - column 4, line 9; figure 1 * | 14,16,19 | |
| | | | **TECHNICAL FIELDS SEARCHED (Int.Cl.7)** |
| | | | G06G |

The present search report has been drawn up for all claims

| Place of search | Date of completion of the search | Examiner |
|---|---|---|
| THE HAGUE | 12 May 2000 | Ledrut, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EP 1 024 450 A1

## ANNEX TO THE EUROPEAN SEARCH REPORT
## ON EUROPEAN PATENT APPLICATION NO.

EP 00 30 0355

This annex lists the patent family members relating to the patent documents cited in the above-mentioned European search report.
The members are as contained in the European Patent Office EDP file on
The European Patent Office is in no way liable for these particulars which are merely given for the purpose of information.

12-05-2000

| Patent document cited in search report | | Publication date | Patent family member(s) | | Publication date |
|---|---|---|---|---|---|
| US 5764559 | A | 09-06-1998 | JP 2669397 B<br>JP 8315055 A<br>GB 2301214 A,B | | 27-10-1997<br>29-11-1996<br>27-11-1996 |
| US 4374335 | A | 15-02-1983 | NONE | | |

EPO FORM P0459

For more details about this annex : see Official Journal of the European Patent Office, No. 12/82

20